# FASCICULE DE BREVET EUROPEEN

(11) **EP 1 903 617 B1**
(45) Date de publication et mention de la délivrance du brevet: **10.06.2015**
(21) Numéro de dépôt: 07116802.5
(22) Date de dépôt: 20.09.2007
(51) Int. Cl.: H01L 31/068

(54) **Procédé de réalisation de régions dopées dans un substrat et de cellules photovoltaïques**
Verfahren zur Herstellung von dotierten Bereichen in einem Substrat und von Sperrschichtphotozellen
Method of producing doped regions in a substrate and photovoltaic cell

(30) Priorité: 22.09.2006 FR 0653906
(43) Date de publication de la demande: 26.03.2008
(73) Titulaire: Commissariat à l'Énergie Atomique et aux Énergies Alternatives, 75015 Paris (FR)
(72) Inventeur: Veschetti, Yannick, 38110 Saint Clair de la Tour (FR); Bettinelli, Armand, 38500, COUBLEVIE (FR)
(74) Mandataire: Ahner, Philippe

(56) Documents cités:
- US-A1- 2004 110 393
- US-B1- 6 998 288

## Description

### DOMAINE TECHNIQUE ET ART ANTÉRIEUR

L'invention concerne le domaine des cellules photovoltaïques, ou solaires, et plus particulièrement celui des cellules photovoltaïques à contacts en face arrière, c'est-à-dire comportant des contacts métalliques et une jonction PN au niveau d'une face opposée à la face destinée à recevoir un rayonnement lumineux.

Les cellules photovoltaïques peuvent comporter des contacts métalliques en face avant (par exemple sous forme de grille) et en face arrière. Il existe également des cellules photovoltaïques, appelées cellules RCC (« Rear Contact Cell » en anglais), ou IBC (« Interdigitated Back Contact » en anglais), comportant la jonction PN et les contacts métalliques uniquement en face arrière. Quelle que soit la structure des contacts métalliques (faces avant et arrière, ou uniquement en face arrière), une cellule photovoltaïque reflète une partie du rayonnement lumineux entrant dans la cellule par la face avant : ce sont les pertes par réflectivité. Par rapport aux cellules comportant des contacts métalliques sur la face avant et sur la face arrière, les cellules RCC ont des pertes par réflectivité moins importantes grâce à l'absence de grille sur la face avant.

Le principe des cellules RCC est d'avoir dans le substrat, au niveau de la face arrière, des zones dopées P et N, appelées également caissons de dopage, formant une jonction PN. Les documents US 4 927 770 et US 5 053 083 décrivent des cellules RCC et des procédés de réalisation de ces cellules.

Le document US 6 998 288 décrit un procédé de réalisation de caissons de dopage en face arrière et d'une couche dopée en face avant d'une cellule RCC. Les étapes de ce procédé sont :
- dépôt d'une première couche d'oxyde de silicium dopé d'un premier type de conductivité sur une face arrière d'un substrat (du côté de la future face arrière de la cellule RCC réalisée) d'un certain type de conductivité par dépôt chimique en phase gazeuse à pression atmosphérique (APCVD),
- dépôt APCVD d'une première couche d'oxyde de silicium intrinsèque sur la première couche d'oxyde de silicium dopé,
- sérigraphie d'un masque de gravure sur la première couche d'oxyde de silicium intrinsèque, définissant la répartition des caissons de dopage du premier type de conductivité dans le substrat,
- gravure chimique des premières couches d'oxyde de silicium dopé et intrinsèque,
- dépôt APCVD d'une seconde couche d'oxyde de silicium dopé d'un second type de conductivité, opposé au premier type de conductivité, sur la première couche d'oxyde de silicium intrinsèque et dans les motifs gravés dans les premières couches d'oxyde de silicium dopé et intrinsèque,
- dépôt APCVD d'une seconde couche d'oxyde de silicium intrinsèque sur la seconde couche d'oxyde de silicium dopé,
- texturation d'une face avant du substrat grâce à une solution d'hydroxyde de potassium,
- recuit du substrat et des couches déposées dans un four de diffusion à tube, formant les caissons de dopage du premier et du second type de conductivité au niveau de la face arrière du substrat, et formant également une couche d'oxyde de silicium dopé au niveau de la face avant texturée du substrat.

Les inconvénients d'un tel procédé sont le coût et le nombre d'étapes nécessaires à la réalisation des caissons de dopage.

Le document de P. Hacke et al. « A screen-printed interdigitated back contact cell using a boron-source diffusion barrier », Solar Energy Materials & Solar Cells 88, 2005, pages 119 à 127, décrit un autre procédé de réalisation de caissons de dopage en face arrière. Une pâte dopante de type P est tout d'abord déposée selon un premier motif sur une face d'un substrat. Le substrat est ensuite soumis à une cuisson, réalisant une diffusion des dopants de la pâte déposée, créant des zones dopées P dans le substrat selon le premier motif. Parallèlement à cette cuisson, une diffusion de dopants de type N est réalisée dans l'ensemble du substrat. La pâte dopante joue le rôle de barrière de diffusion en empêchant les dopants de type N de doper les zones du substrat se trouvant sous cette pâte dopante. On obtient ainsi un substrat dopé N comportant des zones dopées P.

Là encore, les inconvénients d'un tel procédé sont le coût et une mise en oeuvre industrielle difficilement réalisable.

### EXPOSÉ DE L'INVENTION

Un but de la présente invention est de proposer un procédé de réalisation de régions dopées, ou caissons de dopage, dans un substrat, comportant un nombre d'étapes inférieur au nombre d'étapes des procédés de l'art antérieur et qui soit économiquement intéressant pour une mise en oeuvre industrielle.

Pour cela, la présente invention propose un procédé de réalisation de régions dopées sur la face arrière d'une cellule photovoltaïque, comprenant au moins les étapes de :
a) dépôt d'une première pâte dopante comportant des dopants d'un premier type de conductivité sur une face, appelée face arrière, d'un substrat à base de semi-conducteur selon un motif conforme à la répartition souhaitée de régions dopées du premier type de conductivité dans le substrat,
b) dépôt d'une couche d'oxyde au moins sur les portions de la face arrière du substrat non recouvertes par de la pâte dopante,
c) recuit du substrat à une température diffusant les dopants dans le substrat et formant des régions dopées, dans le substrat, sous la pâte dopante.

On entend par recuit du substrat, ici et dans tout le reste du document, un recuit du substrat à base de semi-conducteur et des couches déposées sur le substrat.

Ainsi, le procédé objet de la présente invention permet une réalisation de caissons de dopage en face arrière du substrat tout en protégeant le reste du substrat de l'exo-diffusion des dopants grâce au dépôt d'oxyde réalisé avant l'étape de recuit. L'utilisation de pâtes dopantes permet de réduire les coûts industriels de mise en oeuvre par rapport aux dépôts plasma réalisés durant les procédés de l'art antérieur décrits.

Le procédé peut comporter en outre entre l'étape a) et l'étape b) une étape de dépôt d'une seconde pâte dopante comportant des dopants d'un second type de conductivité, opposé au premier type de conductivité, sur la face arrière du substrat selon un motif conforme à la répartition souhaitée de régions dopées du second type de conductivité dans le substrat, les régions dopées du second type de conductivité ne se superposant pas aux régions dopées du premier type de conductivité.

Ainsi, le procédé permet une réalisation simultanée des caissons de dopage en face arrière du substrat tout en assurant une isolation électrique entre les caissons de dopage formés par l'insertion de l'oxyde avant l'étape de recuit. Ce procédé permet donc de réduire le nombre d'étapes pour la réalisation de régions dopées dans un substrat, notamment lors de la réalisation de cellules RCC.

Le procédé peut comporter en outre, entre l'étapes a) de dépôt de la première pâte dopante et l'étape de dépôt de la seconde pâte dopante, au moins les étapes de :
a1) dépôt d'une couche d'oxyde au moins sur les portions de la face arrière du substrat non recouvertes par la première pâte dopante,
a2) recuit du substrat à une température diffusant les dopants dans le substrat et formant des régions dopées, dans le substrat, sous la pâte dopante,
a3) retrait de la couche d'oxyde et de la pâte dopante se trouvant sur la face arrière du substrat.

Dans ce cas, on optimise le profil du recuit réalisé pour chaque zone dopée en réalisant dans un premier temps les régions dopées du premier type de conductivité, puis dans un deuxième temps les régions dopées du second type de conductivité. Par exemple, la température et la durée de recuit seront adaptées en fonction de la pâte dopante utilisée pour réaliser les régions dopées.

Le procédé peut comporter en outre entre l'étape a1) de dépôt de la couche d'oxyde et l'étape a2) de recuit du substrat, une étape de recuit du substrat à une température égale à environ 500°C. Ainsi, on réalise deux étapes de recuit successivement, à des températures différentes. Ces deux étapes pourront par exemple être mises en oeuvre dans un four de passage infrarouge, le four comportant une première zone de recuit à 500°C, et une seconde zone de recuit pour la diffusion de dopants.

Au moins un recuit du substrat peut être réalisé dans un four à passage infrarouge, c'est-à-dire dont le chauffage est réalisé par des lampes infrarouges.

Le procédé, objet de la présente invention, peut comporter en outre, par exemple avant l'étape a), une étape de dépôt d'une couche d'oxyde sur une face avant du substrat, opposée à la face arrière du substrat.

Le procédé peut également comporter, avant cette étape de dépôt d'une couche d'oxyde sur la face avant du substrat, une étape de texturation de la face avant du substrat.

Le procédé peut comporter en outre entre l'étape b) de dépôt d'une couche d'oxyde et l'étape c) de recuit du substrat à une température diffusant des dopants dans le substrat, une étape de recuit du substrat à une température égale à environ 500°C. Là encore, les deux étapes de recuit successives pourront être mises en oeuvre dans un four de passage infrarouge, tel que décrit précédemment.

Le recuit du substrat à une température diffusant des dopants dans le substrat peut être réalisé au moins partiellement dans un environnement gazeux riche en oxygène.

Le présente invention concerne également un procédé de réalisation de cellule photovoltaïque, comportant au moins les étapes de :
- réalisation de régions dopées dans un substrat à base de semi-conducteur selon l'un des procédés décrit précédemment,
- retrait de restes de la couche d'oxyde et de pâte dopante se trouvant sur la face arrière du substrat,
- réalisation de métallisations sur la face arrière du substrat au niveau des régions dopées.

Ainsi, on peut réaliser des cellules photovoltaïques à partir d'un substrat dont les régions dopées ont été réalisées selon un procédé également objet de la présente invention. Ce procédé de réalisation de cellule photovoltaïque comporte un nombre réduit d'étapes grâce à la réduction du nombre d'étapes pour la réalisation de régions dopées dans un substrat. Les coûts sont également réduits grâce à l'utilisation de pâtes dopantes par rapport aux dépôts plasma réalisés durant les procédés de l'art antérieur. De plus, les cellules photovoltaïques obtenues par le procédé, objet de la présente invention, ont un rendement de conversion supérieur à celui des cellules photovoltaïques standard, c'est-à-dire non RCC.

Les métallisations peuvent être réalisées selon n'importe quel procédé de métallisation adapté à la réalisation de cellules photovoltaïques.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

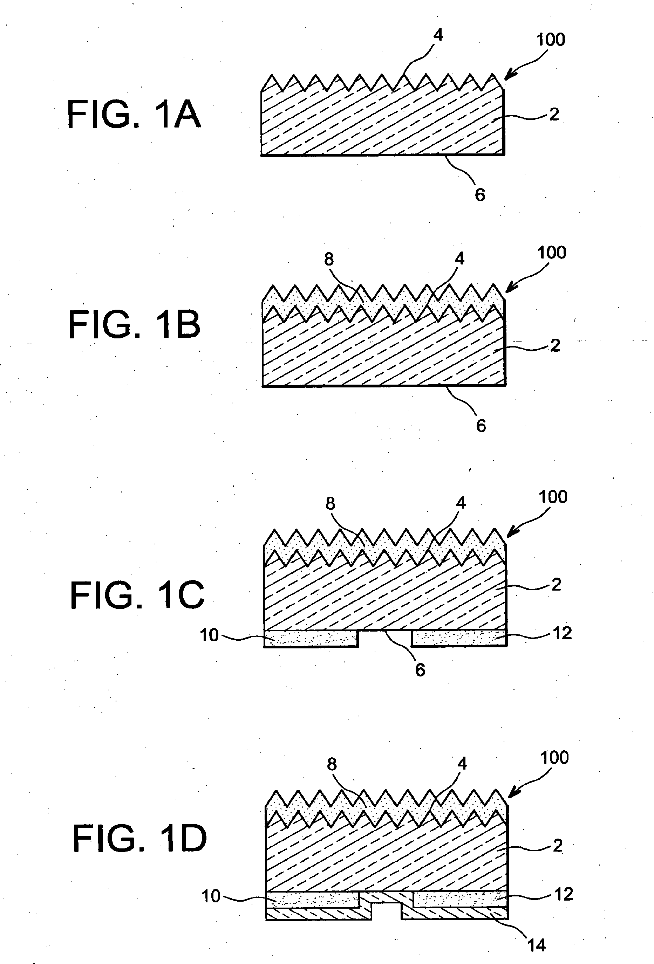

- les figures 1A à 1E représentent les étapes d'un procédé de réalisation de cellule photovoltaïque, objet de la présente invention, selon un premier mode de réalisation, ainsi que les étapes d'un procédé de réalisation de régions dopées dans un substrat, également objet de la présente invention, selon un premier mode de réalisation,

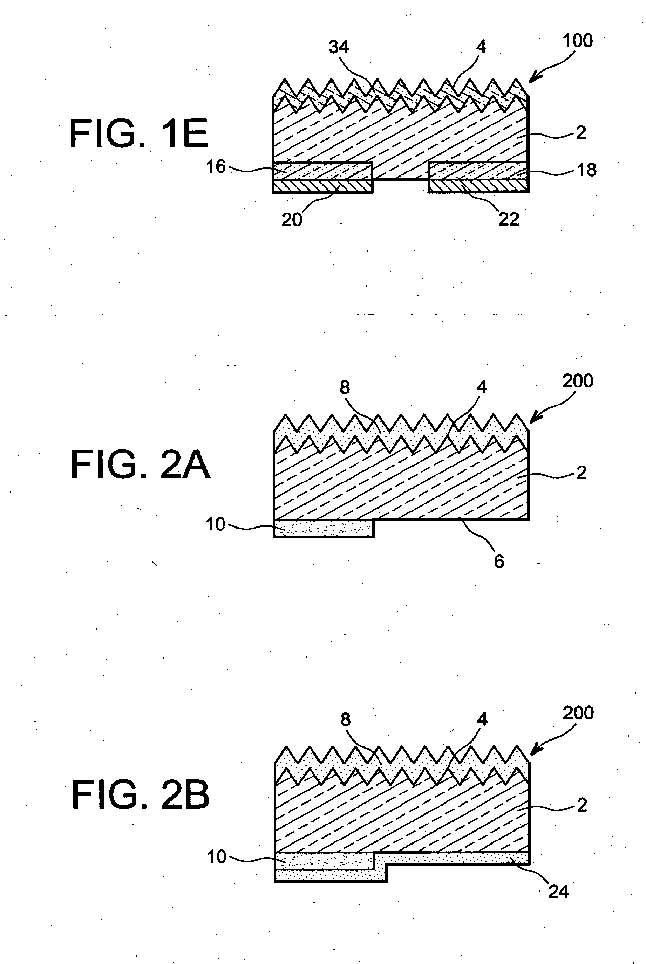

- les figures 2A à 2E représentent les étapes d'un procédé de réalisation de cellule photovoltaïque, objet de la présente invention, selon un second mode de réalisation, ainsi que les étapes d'un procédé de réalisation de régions dopées dans un substrat, également objet de la présente invention, selon un second mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

On se réfère tout d'abord aux figures 1A à 1F qui représentent les étapes d'un procédé de réalisation d'une cellule photovoltaïque 100. Un procédé de réalisation de régions dopées dans un substrat est également décrit en liaison avec ces figures.

Comme représenté sur la figure 1A, on réalise tout d'abord une texturation d'une face avant 4 d'un substrat 2 à base de semi-conducteur, par exemple du silicium cristallin. Cette texturation peut par exemple être obtenue par l'utilisation d'une solution d'hydroxyde de potassium. Le substrat 2 comporte une face arrière 6 polie ou texturée. Le substrat 2 peut être de type P ou N, monocristallin ou multicristallin.

Une couche d'oxyde 8, ici un film mince d'oxyde de silicium, est ensuite déposée sur la face avant 4 texturée du substrat 2 (voir figure 1B). Dans cet exemple de réalisation, cette couche d'oxyde 8 comporte des dopants de type bore ou phosphore ; cette couche d'oxyde 8 pourrait également être intrinsèque. Cette couche d'oxyde 8 est destinée à protéger la face avant 4 lors des étapes suivantes du procédé. Si cette couche d'oxyde 8 comporte des dopants, elle sert également à doper la face avant 4 du substrat 2, comme décrit ultérieurement. Cette couche d'oxyde 8 peut par exemple être obtenue à partir d'une solution dite « spin-on » déposée par centrifugation, puis chauffée pour obtenir un durcissement de cette solution, formant la couche d'oxyde 8. Cette couche d'oxyde 8 peut également être réalisée de manière classique par sérigraphie, par un dépôt de type chimique en phase vapeur (ou CVD), ou encore par « spray », c'est-à-dire par jet (l'oxyde est projeté directement sur la face avant 4 du substrat 2), ou encore par dépôt « rideau » (la face avant 4 du substrat 2 est passée sous un flux continu d'oxyde, formant un « rideau » d'oxyde, pour réaliser la couche 8).

On dépose ensuite sur la face arrière 6 du substrat 2, comme représenté sur la figure 1C, de la pâte dopante 10 d'un premier type de conductivité, ici P, comportant des dopants de type bore, par sérigraphie (étape a). Cette pâte dopante 10 est déposée selon un premier motif conforme à la répartition souhaitée de régions dopées P+ dans le substrat 2, c'est-à-dire aux emplacements où l'on souhaite avoir, dans le substrat 2, les régions dopées P+. De la pâte dopante 12 d'un second type de conductivité, ici N, comportant des dopants de type phosphore, est également déposée, par exemple par sérigraphie, sur la face arrière 6 du substrat 2. Cette pâte dopante 12 est déposée aux emplacements où l'on souhaite avoir, dans le substrat 2, des régions dopées N+. Ces régions dopées N+ et P+ formeront les caissons de dopage réalisant la jonction PN de la cellule photovoltaïque 100. La répartition des pâtes dopantes 10 et 12 peut être facilitée par un alignement par caméra avec présence de mires sur la face arrière 6 du substrat 2, avec une précision de +/- 20 µm. Des exemples de pâtes dopantes sont décrits dans l'article de J. Salami et al. : « Diffusion Paste Development for printable IBC and Bifacial silicon Solar Cells », Proceedings of the 2006 IEEE 4th World Conference on Photovoltaic Energy Conversion, du 7 au 12 mai 2006, Hilton Waikoloa Village, Waikoloa, Hawaii.

Une couche d'oxyde 14, tel un film d'oxyde de silicium, est déposée sur les portions de la face arrière 6 non recouvertes par la pâte dopante 10 ou 12, et sur les portions de pâte dopante 10 et 12 (étape b). Cette couche d'oxyde 14 est ici obtenue par centrifugation d'une solution d'oxyde de silicium type «spin-on» ne solubilisant pas les pâtes dopantes 10 et 12. On peut utiliser comme oxyde des pâtes contenant une poudre fine de SiO₂ et/ou de TiO₂ (dont le diamètre des grain est typiquement inférieur à 5 micromètres, voir inférieur à 1 micromètre) pour obtenir une surface piégeant les dopants de manière efficace, par exemple sous forme de silice colloïdale, silice fondue, quartz, cristobalite, .... Pour cela, les pâtes dopantes 10, 12 sont par exemple à base d'une résine d'éthylcellulose solubilisée dans un solvant de type terpinéol, et la couche d'oxyde 14 est à base d'une résine d'hydroxypropylcellulose solubilisée dans un solvant de type propyleneglycol. Dans ce cas, un premier recuit peut être réalisé à une température égale à environ 500°C, permettant un « déliantage » des pâtes dopantes 10 et 12 et de la couche d'oxyde 14, c'est-à-dire supprimant les liants organiques se trouvant dans les pâtes dopantes 10 et 12 et dans la couche d'oxyde 14. Ce premier recuit peut par exemple être réalisé dans un four à passage infrarouge. La couche d'oxyde 14 peut également être réalisée par d'autres techniques tel que le dépôt d'un film d'oxyde par sérigraphie, ou par un dépôt de type CVD.

On réalise ensuite un recuit du substrat 2 à une température diffusant les dopants des pâtes dopantes 10 et 12 dans le substrat 2 et formant simultanément des régions dopées P+ 16 et N+ 18, représentées sur la figure 1E, dans le substrat 2, sous les motifs formés par les pâtes dopantes 10 et 12. Cette température de recuit peut par exemple être comprise entre environ 950°C et 1000°C, pendante une durée par exemple comprise entre environ 10mn et 30mn. Ce recuit peut être réalisé dans un four à passage infrarouge permettant un recuit rapide du substrat 2 avec un passage en ligne adapté à une production industrielle. Ainsi, il est possible de réaliser successivement les deux étapes de recuit dans un même four à passage infrarouge, le four comportant par exemple une première zone de chauffe à environ 500°C, puis une seconde zone de chauffe à environ 950°C pour réaliser la diffusion des dopants dans le substrat 2. La couche d'oxyde 8 permet d'empêcher l'exo-diffusion de dopants entre les pâtes dopantes 10, 12 et le substrat 2 lors du recuit. Ainsi, les régions dopées 16 et 18 obtenues sont bien isolées les unes des autres. La couche d'oxyde 8 étant dans cet exemple dopée, une couche dopée 34 est également formée dans le substrat 2 au niveau de la face avant 4, grâce aux dopants présents dans la couche d'oxyde 8, assurant la passivation de la face avant 4. Un ajout d'oxygène en fin de recuit peut être réalisé pour pouvoir graver les résidus de pâtes dopantes, alors transformés en verre par le recuit, avec de l'acide fluorhydrique. Cet ajout d'oxygène peut par exemple être réalisé dans un environnement gazeux riche en oxygène se trouvant dans une partie du four de passage infrarouge. La couche d'oxyde 8 est également retirée de la face avant 4 du substrat 2.

Des métallisations 20 et 22 sont ensuite respectivement réalisées sur les régions dopées 16 et 18, contactant ainsi la jonction PN de la cellule photovoltaïque 100.

On obtient une cellule photovoltaïque 100 comportant une face avant 4 texturée et passivée, et des caissons dopés, P+ 16 et N+ 18, isolés entre eux dans le substrat 2. La couche dopée 34 permet de réduire les recombinaisons au niveau de la face avant de la cellule 100 durant la conversion photovoltaïque de l'énergie solaire reçue.

Les figures 2A à 2E représentent respectivement les étapes d'un procédé de réalisation d'une cellule photovoltaïque 200. Un procédé de réalisation de régions dopées dans un substrat sera également décrit en liaison avec ces figures.

On réalise tout d'abord une texturation d'une face avant 4 d'un substrat 2 par exemple similaire au substrat 2 décrit sur les figures 1A à 1E.

Une couche d'oxyde 8, par exemple un film mince d'oxyde de silicium, est ensuite déposée, par exemple par sérigraphie, « spray » ou dépôt « rideau » ou centrifugation et chauffage d'une solution dite « spin-on » sur la face avant 4 du substrat 2 (voir figure 2A). Dans cet exemple, la couche d'oxyde 8 ne comprend pas de dopants et est destinée à protéger la face avant 4 lors des étapes de recuit suivantes du procédé. Mais comme dans l'exemple précédent, la couche d'oxyde 8 pourrait contenir des dopants.

On dépose ensuite sur la face arrière 6 du substrat 2, comme représenté sur la figure 2A, de la pâte dopante 10 d'un premier type de conductivité, ici P, à base de bore, par sérigraphie, de manière similaire à la figure 1C.

On dépose ensuite une couche d'oxyde 24, par exemple à base d'oxyde de silicium, sur les parties de la face 6 non recouvertes par la pâte dopante 10 et sur la pâte dopante 10, par exemple par centrifugation et chauffage (voir figure 2B). On réalise un premier recuit du substrat 2 à une température égale à environ 500°C pour réaliser un déliantage de la pâte dopante 10 et de la couche d'oxyde 24. Un second recuit du substrat 2, par exemple dans un four de passage infrarouge, forme les régions dopées P+ 16 dans le substrat 2. Là encore, il est possible de réaliser successivement les deux étapes de recuit dans un même four à passage infrarouge, le four comportant par exemple une première zone de chauffe à environ 500°C, puis une seconde zone de chauffe à environ 1000°C pour réaliser la diffusion des dopants dans le substrat 2. Ce second recuit peut par exemple être réalisé à une température comprise entre environ 950°C et 1000°C pendant une durée comprise entre environ 10mn et 30mn. La couche d'oxyde 24 et les restes de la pâte dopante 10 sont ensuite retirés chimiquement de la face arrière 6 du substrat 2. A ce stade du procédé, il est possible de remplacer la couche d'oxyde intrinsèque 8 par une couche d'oxyde dopée qui viendra doper la face avant 4 du substrat 2 pendant la formation ultérieure des régions dopées N+ 18.

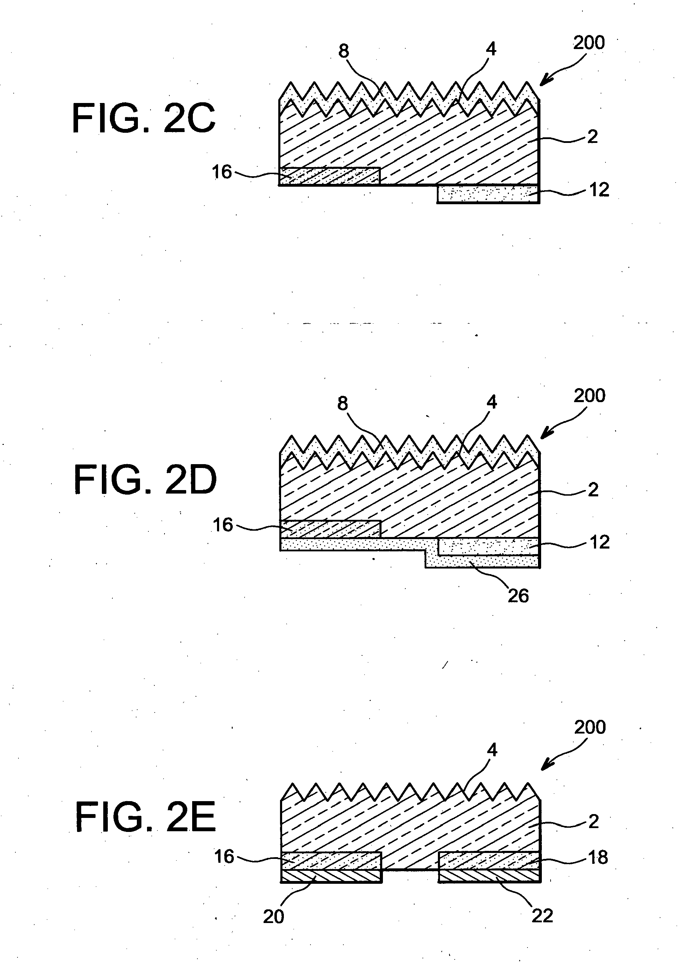

De la pâte dopante 12 d'un second type de conductivité, ici N, à base de phosphore, est alors déposée (voir figure 2C) sur la face arrière 6 du substrat 2, aux emplacement où l'on souhaite obtenir les régions dopées N+ 18 représentées sur la figure 2E. La pâte dopante 12 est déposée sur des parties de la face 6 du substrat 2 qui n'ont pas été précédemment dopées par la pâte dopante 10. Une autre couche d'oxyde 26, par exemple de nature similaire à la couche d'oxyde 24, est déposée par centrifugation sur les parties de la face 6 non recouvertes par la pâte dopante 12 et sur la pâte dopante 12 (figure 2D). On réalise un troisième recuit à une température environ égale à 500°C pour « délianter » la pâte dopante 12 et la couche d'oxyde 26. Le substrat 2 subi enfin un quatrième recuit, là encore dans un four de passage infrarouge, par exemple à une température comprise entre environ 850°C et 900°C, pendant une durée comprise entre 10 mn et 30 mn, formant les régions dopées N+ 18 dans le substrat 2 (figure 2E). Si la couche d'oxyde intrinsèque 8 a été remplacée par une couche d'oxyde dopée, alors ce quatrième recuit de la face avant 4 réalise également un dopage de cette face avant 4.

La couche d'oxyde 26 et les restes de la pâte dopante 12 sont retirés du substrat 2 par des techniques similaires à celles employées précédemment pour retirer les restes de la pâte dopante 10 et la couche d'oxyde 24.

De préférence, on choisira de déposer en premier lieu celle de la pâte dopante 10 ou de la pâte dopante 12 nécessitant un recuit à la plus haute température pour la diffusion des dopants dans le substrat. Ainsi, le recuit réalisé pour diffuser les dopants de l'autre pâte dopante ne viendra pas ou peu modifier le dopage réalisé précédemment.

Des métallisations 20, 22 peuvent ensuite être réalisées sur ces régions dopées 16 et 18, par exemple de manière similaire à celle exposée précédemment pour le premier mode de réalisation.

## Revendications

1. Procédé de réalisation de régions dopées (16, 18) sur la face arrière d'une cellule photovoltaïque (100, 200), comprenant au moins, dans cet ordre, les étapes de :
a) dépôt d'une première pâte dopante (10) comportant des dopants d'un premier type de conductivité sur une face (6), appelée face arrière, d'un substrat (2) à base de semi-conducteur selon un motif conforme à la répartition souhaitée de régions dopées (16) du premier type de conductivité dans le substrat (2),
b) dépôt d'une couche d'oxyde (14, 26) au moins sur les portions de la face arrière (6) du substrat (2) non recouvertes par de la pâte dopante (10, 12),
c) recuit du substrat (2) à une température diffusant les dopants dans le substrat (2) et formant des régions dopées (16, 18), dans le substrat (2), sous la pâte dopante (10, 12).

2. Procédé selon la revendication 1, comportant en outre entre l'étape a) et l'étape b), une étape de dépôt d'une seconde pâte dopante (12) comportant des dopants d'un second type de conductivité, opposé au premier type de conductivité, sur la face arrière (6) du substrat (2) selon un motif conforme à la répartition souhaitée de régions dopées (18) du second type de conductivité dans le substrat (2), les régions dopées (18) du second type de conductivité ne se superposant pas aux régions dopées (16) du premier type de conductivité.

3. Procédé selon la revendication 2, comportant en outre, entre l'étape a) de dépôt de la première pâte dopante (10) et l'étape de dépôt de la seconde pâte dopante (12), au moins les étapes de :
a1) dépôt d'une couche d'oxyde (24) au moins sur les portions de la face arrière (6) du substrat (2) non recouvertes par la première pâte dopante (10),
- a2) recuit du substrat (2) à une température diffusant les dopants dans le substrat (2) et formant des régions dopées (16), dans le substrat (2), sous la pâte dopante (10),
a3) retrait de la couche d'oxyde (24) et de la pâte dopante (10) se trouvant sur la face arrière (6) du substrat (2).

4. Procédé selon la revendication 3, comportant en outre entre l'étape a1) de dépôt de la couche d'oxyde (24) et l'étape a2) de recuit du substrat (2), une étape de recuit du substrat (2) à une température égale à environ 500°C.

5. Procédé selon l'une des revendications précédentes, le dépôt de pâte dopante (10, 12) étant réalisé par sérigraphie.

6. Procédé selon l'une des revendications précédentes, le dépôt de couche d'oxyde (14, 24, 26) étant réalisé par centrifugation puis chauffage, ou par jet, ou par passage sous un flux d'oxyde.

7. Procédé selon l'une des revendications précédentes, la ou les pâte(s) dopante(s) (10, 12) étant à base d'une résine d'éthylcellulose solubilisée dans un solvant de type terpinéol.

8. Procédé selon l'une des revendications précédentes, l'oxyde (14, 24, 26) utilisé étant de l'oxyde de silicium à base d'une résine d'hydroxypropylcellulose solubilisée dans un solvant type propyleneglycol.

9. Procédé selon l'une des revendications précédentes, au moins un recuit du substrat (2) étant réalisé dans un four à passage infrarouge.

10. Procédé selon l'une des revendications précédentes, comportant en outre une étape de dépôt d'une couche d'oxyde (8) sur une face avant (4) du substrat (2), opposée à la face arrière (6) du substrat (2).

11. Procédé selon la revendication 10, la couche d'oxyde (8) déposée sur la face avant (4) du substrat (2) comportant des dopants.

12. Procédé selon l'une des revendications 10 ou 11, comportant en outre, avant l'étape de dépôt d'une couche d'oxyde (8) sur la face avant (4) du substrat (2), une étape de texturation de la face avant (4) du substrat (2).

13. Procédé selon l'une des revendications précédentes, comportant en outré, entre l'étape b) et l'étape c), une étape de recuit du substrat (2) à une température égale à environ 500°C.

14. Procédé selon la revendication 13, le recuit du substrat (2) à une température d'environ 500°C étant réalisé dans un four à passage infrarouge.

15. Procédé selon l'une des revendications 13 ou 14, le recuit du substrat (2) à une température diffusant des dopants dans le substrat (2) étant réalisé au moins partiellement dans un environnement gazeux riche en oxygène.

## Patentansprüche

1. Verfahren zum Herstellen von dotierten Bereichen (16, 18) auf der Hinterseite einer photovoltaischen Zelle (100, 200), das zumindest die nachfolgenden Schritte in dieser Reihenfolge umfasst:
a) Aufbringen einer ersten Dotierpaste (10) mit Dotierungsmitteln eines ersten Leitfähigkeitstyps auf eine Seite (6), die sogenannte Hinterseite, eines Substrats (2) auf Halbleiterbasis nach einem Muster, das der gewünschten Verteilung von dotierten Bereichen (16) des ersten Leitfähigkeitstyps in dem Substrat (2) entspricht,
b) Aufbringen einer Oxidschicht (14, 26) zumindest auf Abschnitte der Hinterseite (6) des Substrats (2), die nicht mit der Dotierpaste (10, 12) bedeckt sind,
c) Tempern des Substrats (2) bei einer Temperatur, bei der die Dotierungsmittel in das Substrat (2) diffundieren und im Substrat dotierte Bereiche (16, 18) unter der Dotierpaste (10, 12) gebildet werden.

2. Verfahren nach Anspruch 1, ferner umfassend zwischen Schritt a) und Schritt b) einen Schritt des Aufbringens einer zweiten Dotierpaste (12) mit Dotierungsmitteln eines zweiten Leitfähigkeitstyps, der dem ersten Leitfähigkeitstyp entgegengesetzt ist, auf die Hinterseite (6) des Substrats (2) nach einem Muster, das der gewünschten Verteilung von dotierten Bereichen (18) des zweiten Leitfähigkeitstyps in dem Substrat (2) entspricht, wobei die dotierten Bereiche (18) des zweiten Leitfähigkeitstyps sich nicht mit den dotierten Bereichen (16) des ersten Leitfähigkeitstyps überlagern.

3. Verfahren nach Anspruch 2, ferner umfassend zwischen Schritt a) des Aufbringens der ersten Dotierpaste (10) und dem Schritt des Aufbringens der zweiten Dotierpaste (12) zumindest die nachfolgenden Schritte:
a1) Aufbringen einer Oxidschicht (24) zumindest auf die Abschnitte der Hinterseite (6) des Substrats (2), die nicht mit der ersten Dotierpaste (10) bedeckt sind,
a2) Tempern des Substrats (2) bei einer Temperatur, bei der die Dotierungsmittel in das Substrat (2) diffundieren und im Substrat dotierte Bereiche (16) unter der Dotierpaste (10) gebildet werden,
a3) Entfernen der Oxidschicht (24) und der Dotierpaste (10), die sich auf der Hinterseite (6) des Substrats (2) befindet.

4. Verfahren nach Anspruch 3, ferner umfassend zwischen Schritt a1) des Aufbringens der Oxidschicht (24) und dem Schritt a2) des Temperns des Substrats (2) einen Schritt des Temperns des Substrats (2) bei einer Temperatur, die gleich etwa 500 °C ist.

5. Verfahren nach einem der vorangehenden Ansprüche, wobei das Aufbringen der Dotierpaste (10, 12) durch Siebdruck erfolgt.

6. Verfahren nach einem der vorangehenden Ansprüche, wobei das Aufbringen der Oxidschicht (14, 24, 26) durch Zentrifugieren gefolgt von Erhitzen bzw. durch Strahl bzw. durch Strömen unter einem Oxidfluss erfolgt.

7. Verfahren nach einem der vorangehenden Ansprüche, wobei die Dotierpaste bzw. Dotierpasten (10, 12) auf Basis von einem Ethylcellulose-Harz bestehen, das in einem Lösungsmittel vom Typ Terpineol löslich gemacht ist.

8. Verfahren nach einem der vorangehenden Ansprüche, wobei das verwendete Oxid (14, 24, 26) Siliziumoxid auf Basis eines Hydroxypropylcellulose-Harzes ist, das in einem Lösungsmittel vom Typ Propylenglycol löslich gemacht ist.

9. Verfahren nach einem der vorangehenden Ansprüche, wobei zumindest ein Tempern des Substrats (2) in einem Infrarot-Durchlaufofen erfolgt.

10. Verfahren nach einem der vorangehenden Ansprüche, ferner umfassend einen Schritt des Aufbringens einer Oxidschicht (8) auf eine Vorderseite (4) des Substrats (2), die der Hinterseite (6) des Substrats (2) entgegengesetzt ist.

11. Verfahren nach Anspruch 10, wobei die auf die Vorderseite (4) des Substrats (2) aufgebrachte Oxidschicht (8) Dotierungsmittel enthält.

12. Verfahren nach einem der Ansprüche 10 oder 11, ferner umfassend vor dem Schritt des Aufbringens einer Oxidschicht (8) auf die Vorderseite (4) des Substrats (2) einen Schritt des Texturierens der Vorderseite (4) des Substrats (2).

13. Verfahren nach einem der vorangehenden Ansprüche, ferner umfassend zwischen dem Schritt b) und dem Schritt c) einen Schritt des Temperns des Substrats (2) bei einer Temperatur, die gleich etwa 500 °C ist.

14. Verfahren nach Anspruch 13, wobei das Tempern des Substrats (2) bei einer Temperatur von etwa 500 °C in einem Infrarot-Durchlaufofen erfolgt.

15. Verfahren nach einem der Ansprüche 13 oder 14, wobei das Tempern des Substrats (2) bei einer Temperatur, bei der Dotierungsmittel in das Substrat (2) diffundieren, zumindest teilweise in einer sauerstoffreichen, gasförmigen Umgebung erfolgt.

## Claims

1. Method for producing doped regions (16, 18) on the rear face of a photovoltaic cell (100, 200), comprising at least, in this order, the steps of:
a) depositing a first doping paste (10) comprising doping agents with a first type of conductivity on a face (6), called the rear face, of a semiconductor-based substrate (2) according to a pattern consistent with the desired distribution of regions (16) doped with the first type of conductivity in the substrate (2),
b) depositing an oxide layer (14, 26) at least on the portions of the rear face (6) of the substrate (2) not covered with the doping paste (10, 12),
c) annealing the substrate (2) at a temperature diffusing the doping agents in the substrate (2) and forming doped regions (16, 18), in the substrate (2), under the doping paste (10, 12).

2. Method according to claim 1, also comprising, between step a) and step b), a step of depositing a second doping paste (12) comprising doping agents with a second type of conductivity, opposite the first type of conductivity, on the rear face (6) of the substrate (2) according to a pattern consistent with the desired distribution of regions (18) doped with a second type of conductivity in the substrate (2), wherein the regions (18) doped with a second type of conductivity are not superimposed on the regions (16) doped with the first type of conductivity.

3. Method according to claim 2, also comprising between step a) of depositing the first doping paste (10) and the step of depositing the second doping paste (12), at least the steps of:
a1) depositing an oxide layer (24) on at least the portions of the rear face (6) of the substrate (2) not covered by the first doping paste (10),
a2) annealing the substrate (2) at a temperature diffusing the doping agents in the substrate (2) and forming doped regions (16), in the substrate (2), under the doping paste (2),
a3) removing the oxide layer (24) and the doping paste (10) located on the rear face (6) of the substrate (2).

4. Method according to claim 3, also comprising, between step a1) of depositing the oxide layer (24) and step a2) of annealing the substrate (2), a step of annealing the substrate (2) at a temperature equal to around 500 °C.

5. Method according to one of the previous claims, the deposition of the doping paste (10, 12) being performed by screen printing.

6. Method according to one of the previous claims, the deposition of the oxide layer (14, 24, 26) being performed by centrifugation then heating, or by spraying, or by passing under an oxide flux.

7. Method according to one of the previous claims, the doping paste(s) (10, 12) being based on an ethylcellulose resin solubilised in a terpineol-type solvent.

8. Method according to one of the previous claims, oxide (14, 24, 26) used being silicon oxide based on a hydroxypropylcellulose resin solubilised in a propyleneglycol-type solvent.

9. Method according to one of the previous claims, at least one annealing of the substrate (2) being performed in an infrared continuous furnace.

10. Method according to one of the previous claims, also comprising a step of depositing an oxide layer (8) on a front face (4) of the substrate (2) opposite the rear face (6) of the substrate (2).

11. Method according to claim 10, the oxide layer (8) deposited on the front face (4) of the substrate (2) comprising doping agents.

12. Method according to one of claims 10 or 11, also comprising, before the step depositing an oxide layer (8) on a front face (4) of the substrate (2), a step of texturation of the front face (4) of the substrate (2).

13. Method according to one of the previous claims, also comprising, between step b) and step c), a step of annealing the substrate (2) at a temperature equal to around 500 °C.

14. Method according to claim 13, the annealing of the substrate (2) at a temperature of around 500 °C being performed in an infrared continuous furnace.

15. Method according to one of claims 13 or 14, the annealing of the substrate (2) at a temperature diffusing doping agents in the substrate (2) being performed at least partially in an oxygen-rich gaseous environment.
